(19) Europäisches Patentamt
European Patent Office
Office européen des brevets

(11) EP 4 350 790 A1

(12) EUROPEAN PATENT APPLICATION
published in accordance with Art. 153(4) EPC

(43) Date of publication:
10.04.2024 Bulletin 2024/15

(21) Application number: 22815873.9

(22) Date of filing: 19.05.2022

(51) International Patent Classification (IPC):
$H01L\ 41/187^{(2006.01)}$  $B41J\ 2/14^{(2006.01)}$
$H01L\ 27/11507^{(2017.01)}$  $H01L\ 41/09^{(2006.01)}$

(52) Cooperative Patent Classification (CPC):
H10N 30/8554; H01L 28/55; H10B 53/30;
H10N 30/04; H10N 30/1051; H10N 30/877

(86) International application number:
PCT/JP2022/020869

(87) International publication number:
WO 2022/255121 (08.12.2022 Gazette 2022/49)

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
Designated Validation States:
KH MA MD TN

(30) Priority: 03.06.2021 JP 2021093593

(71) Applicant: KONICA MINOLTA, INC.
Tokyo 100-7015 (JP)

(72) Inventors:
• MATSUSHITA, Yuji
 Tokyo 100-7015 (JP)
• HARA, Shintaro
 Tokyo 100-7015 (JP)
• MASHIMA, Hideki
 Tokyo 100-7015 (JP)

(74) Representative: Gille Hrabal
Partnerschaftsgesellschaft mbB
Patentanwälte
Brucknerstraße 20
40593 Düsseldorf (DE)

(54) **PIEZOELECTRIC ELEMENT, DROPLET DISCHARGE HEAD, FERROELECTRIC MEMORY, AND PIEZOELECTRIC ACTUATOR**

(57) A problem to be solved by the present invention is to provide a piezoelectric element with less degradation of piezoelectric characteristics in association with use, a droplet discharge head, a ferroelectric memory and a piezoelectric actuator including the piezoelectric element.

The piezoelectric element of the present invention includes a first electrode, a second electrode and a piezoelectric film located between the first electrode and the second electrode, the first electrode is an electrode to which a relatively positive voltage is applied when the first electrode is driven, the second electrode is an electrode to which a relatively negative voltage is applied when the second electrode is driven, and a coefficient A obtained by the following logarithmic approximation formula in an aging test in which an electric field of 10 V/$\mu$m is applied at an ambient temperature of 80°C is equal to or greater than -4.200 $\times$ $10^{-2}$.

$$\Phi_2 = A \times \ln(t) + B$$

$\Phi_2$: Schottky barrier height [eV] between the second electrode and the piezoelectric film when a positive electric field of 12.68 V/$\mu$m is applied to the first electrode
t: Aging period [h]
A: Coefficient
B: Coefficient

FIG. 3

EP 4 350 790 A1

**Description**

TECHNICAL FIELD

The present invention relates to a piezoelectric element, a droplet discharge head, a ferroelectric memory, and a piezoelectric actuator.

More particularly, the present invention relates to a piezoelectric element, and the like, with less degradation of piezoelectric characteristics in association with use.

BACKGROUND ART

It is known that piezoelectric characteristics of a piezoelectric element degrade by a leak current slightly flowing when a voltage is applied. A leak current that becomes a cause of degradation of piezoelectric characteristics tends to increase as a voltage and a temperature upon application are higher.

Further, even if the voltage and the temperature are the same, continuous or intermittent application of a voltage makes it easier for this leak current to flow, and the leak current increases over time. Increase of the leak current over time is one cause of degradation of piezoelectric characteristics in association with use.

As a technique for preventing degradation of piezoelectric characteristics, for example, a technique of improving durability in a high-humidity and high-temperature environment by preventing concentration of stress by alleviating high stress generated locally and finely in a piezoelectric film upon application of a voltage is disclosed (see Patent Literature 1).

Further, as another technique, a technique of preventing generation of a tunnel current or a Poole-Frenkel current when a piezoelectric element is driven using a drive system that drives the piezoelectric element with a maximum voltage lower than a voltage at which the tunnel current or the Poole-Frenkel current starts to be generated in the piezoelectric element is disclosed (see Patent Literature 2).

As described above, some techniques of preventing degradation of piezoelectric characteristics are disclosed. However, to extend the life of a piezoelectric element, further prevention of degradation is desired, and solutions with different viewpoints are desired.

CITATION LIST

PATENT LITERATURES

[Patent Literature 1]
JP 2010-70394A

[Patent Literature 2]

SUMMARY OF THE INVENTION

TECHNICAL PROBLEM

The present invention has been made in view of the above-described problem and circumstances, and a problem to be solved by the present invention is to provide a piezoelectric element with less degradation of piezoelectric characteristics in association with use, a droplet discharge head, a ferroelectric memory, and a piezoelectric actuator including the piezoelectric element.

SOLUTION TO PROBLEM

The present inventors have studied causes, and the like, of the above-described problem to solve the above-described problem, have found that a piezoelectric element, and the like, with less degradation of piezoelectric characteristics in association with use can be provided, the piezoelectric element including a first electrode, a second electrode, and a piezoelectric film located between the first electrode and the second electrode by making a degree of degradation due to aging smaller under specific conditions of a Schottky barrier height between the second electrode and the piezoelectric film, and have achieved the present invention.

In other words, the problem according to the present invention can be solved by the following means.

1. A piezoelectric element including a first electrode, a second electrode, and a piezoelectric film located between the first electrode and the second electrode, in which

the first electrode is an electrode to which a relatively positive voltage is applied when the first electrode is driven, the second electrode is an electrode to which a relatively negative voltage is applied when the second electrode is driven, and
a coefficient A obtained by the following logarithmic approximation formula in an aging test in which an electric field of 10 V/$\mu$m is applied at an ambient temperature of 80°C is equal to or greater than -4.200 $\times$ 10$^{-2}$.

$$\Phi_2 = A \times \ln(t) + B$$

$\Phi_2$: Schottky barrier height [eV] between the second electrode and the piezoelectric film when a positive electric field of 12.68 V/$\mu$m is applied to the first electrode
t: Aging period [h]
A: Coefficient
B: Coefficient

2. The piezoelectric element according to the first item, in which the coefficient A is equal to or greater than -1.000 $\times$ 10$^{-2}$.

3. The piezoelectric element according to the first item or the second item, in which a crystal structure of a material of the piezoelectric film is a perovskite structure, and
a thickness of the piezoelectric film falls within a range from 0.1 to 5 $\mu$m.

4. The piezoelectric element according to any one of the first to the third items, in which a material of the piezoelectric film is lead zirconate titanate.

5. The piezoelectric element according to any one of the first to the fourth items, in which a material of the piezoelectric film is lead zirconate titanate represented by Pb$_X$(Zr$_Y$, Ti$_{1-Y}$)O$_3$ [0.5 $\leq$ X $\leq$ 1.5, 0.1 $\leq$ Y $\leq$ 0.9] in a whole of the piezoelectric film, and
in a case where when the piezoelectric film is divided in half in a thickness direction, an atomic composition ratio X of lead on the first electrode side is set as X1, and an atomic composition ratio X of lead on the second electrode side is set as X2, a value of a ratio X1/X2 is equal to or greater than 1.04.

6. The piezoelectric element according to any one of the first to the fifth items, including a dielectric film on the second electrode side between the second electrode and the piezoelectric film,
in which a crystal lattice volume of a material of the dielectric film on the second electrode side is smaller than a crystal lattice volume of a material of the piezoelectric film.

7. The piezoelectric element according to the sixth item, in which a crystal structure of the material of the dielectric film on the second electrode side is a perovskite structure, and
a total thickness of the piezoelectric film and the dielectric film on the second electrode side falls within a range from 0.1 to 5 $\mu$m.

8. The piezoelectric element according to the sixth or the seventh item, including a dielectric film on the first electrode side between the first electrode and the piezoelectric film,
in which a total thickness of the dielectric film on the second electrode side and the dielectric film on the first electrode side falls within a range from 5 to 15% of a total thickness of the dielectric film on the second electrode side, the dielectric film on the first electrode side and the piezoelectric film.

9. The piezoelectric element according to any one of the sixth to the eighth items, in which the material of the dielectric film on the second electrode side is lead lanthanum titanate.

10. The piezoelectric element according to any one of the first to the ninth items, in which a Schottky barrier height $\Phi_2$ between the second electrode and the piezoelectric film when a positive electric field of 12.68 V/$\mu$m is applied to the first electrode before an aging test is equal to or greater than 0.5 eV.

11. A droplet discharge head including a piezoelectric element,
the piezoelectric element being a piezoelectric element according to any one of the first to the tenth items.

12. A ferroelectric memory including a piezoelectric element,
the piezoelectric element being a piezoelectric element according to any one of the first to the tenth items.

13. A piezoelectric actuator including a piezoelectric element,
the piezoelectric element being a piezoelectric element according to any one of the first to the tenth items.

ADVANTAGEOUS EFFECTS OF INVENTION

According to the above-described means of the present invention, it is possible to provide a piezoelectric element with less degradation of piezoelectric characteristics in association with use, a droplet discharge head, a ferroelectric memory, and a piezoelectric actuator including the piezoelectric element.

A mechanism of expression or a mechanism of action of effects of the present invention is inferred as follows.

As described above, increase of a leak current over time causes degradation of piezoelectric characteristics. While this increase of the leak current over time occurs by continuous or intermittent application of a voltage, as one cause of this, lowering of a Schottky barrier height can be considered.

In the present invention, the inventors have focused attention on lowering of the Schottky barrier height between the second electrode and the piezoelectric film by continuous or intermittent application of a voltage to the piezoelectric element and increase of a leak current due to the lowering of the Schottky barrier height and have found that increase of a leak current and degradation of piezoelectric characteristics due to the increase of the leak current can be prevented by reducing a degree of lowering of the Schottky barrier height due to aging within a specific range.

Specifically, the inventors have found that by setting the coefficient A in the above-described logarithmic approximation formula obtained in the aging test under the above-described conditions at equal to or greater than - 4.200 $\times$ $10^{-2}$, increase of the leak current and degradation of the piezoelectric characteristics due to the increase of the leak current can be prevented.

Here, the coefficient A becomes an index of a degree of prevention of lowering of the Schottky barrier height. The coefficient A is a value equal to or less than 0, and the greater value, that is, the value closer to 0 indicates a smaller degree of lowering of the Schottky barrier height.

According to the mechanism of expression or mechanism of action, it is possible to provide a piezoelectric element with less degradation of piezoelectric characteristics in association with use.

BRIEF DESCRIPTION OF THE DRAWINGS

[FIG. 1] FIG. 1 is a schematic cross-sectional view of a configuration example of a piezoelectric element.
[FIG. 2] FIG. 2 is a schematic view illustrating change of band alignment by lead diffusion and charge injection.
[FIG. 3] FIG. 3 is a graph in which aging period t and a Schottky barrier height $\Phi_2$ in examples are plotted.
[FIG. 4] FIG. 4 is a graph in which ln(E) and ln(J/T$^2$) in an example (droplet discharge head No. 1) are plotted.
[FIG. 5] FIG. 5 is a graph indicating change of a P-E loop in association with aging in the example (droplet discharge head No. 1).
[FIG. 6] FIG. 6 is a graph indicating change of a P-E loop in association with aging in an example (droplet discharge head No. 2).
[FIG. 7] FIG. 7 is a graph indicating change of a coercive electric field in association with aging in the example (droplet discharge head No. 1).
[FIG. 8] FIG. 8 is a graph indicating change of a coercive electric field in association with aging in the example (droplet discharge head No. 2).
[FIG. 9] FIG. 9 is a graph indicating change of residual polarization in association with aging in the example (droplet discharge head No. 1).
[FIG. 10] FIG. 10 is a graph indicating change of residual polarization in association with aging in the example (droplet discharge head No. 2).

DETAILED DESCRIPTION

A piezoelectric element of the present invention includes a first electrode, a second electrode, and a piezoelectric film located between the first electrode and the second electrode, the first electrode is an electrode to which a relatively positive voltage is applied when the first electrode is driven, the second electrode is an electrode to which a relatively negative voltage is applied when the second electrode is driven, and a coefficient A obtained by the following logarithmic approximation formula in an aging test in which an electric field of 10 V/$\mu$m is applied at an ambient temperature of 80°C is equal to or greater than -4.200 $\times$ $10^{-2}$.

This feature is a technical feature common to or corresponding to the following embodiment.

As the embodiment of the piezoelectric element of the present invention, the coefficient A is preferably equal to or greater than -1.000 $\times$ $10^{-2}$. This makes it possible to further reduce degradation of the piezoelectric characteristics in association with use.

As the embodiment of the piezoelectric element of the present invention, a crystal structure of a material of the piezoelectric film is preferably a perovskite structure, and a thickness of the piezoelectric film preferably falls within a range from 0.1 to 5 $\mu$m. By this means, displacement generation force required for the piezoelectric element can be obtained.

As the embodiment of the piezoelectric element of the present invention, a material of the piezoelectric film is preferably lead zirconate titanate. This makes it possible to form a piezoelectric element having favorable performance.

As the embodiment of the piezoelectric element of the present invention, the material of the piezoelectric film is preferably lead zirconate titanate represented by $Pb_X(Zr_Y, Ti_{1-Y})O_3$ [$0.5 \leq X \leq 1.5$, $0.1 < Y < 0.9$], and in a case where, when the piezoelectric film is divided in half in a thickness direction, an atomic composition ratio X of lead on the first electrode side is set as X1, and an atomic composition ratio X of lead on the second electrode side is set as X2, a value of a ratio X1/X2 is preferably equal to or greater than 1.04. This makes it possible to further prevent lowering of the Schottky barrier height in association with use.

As the embodiment of the piezoelectric element of the present invention, a dielectric film on the second electrode side is preferably provided between the second electrode and the piezoelectric film, and a crystal lattice volume of a material of the dielectric film on the second electrode side is preferably smaller than a crystal lattice volume of the material of the piezoelectric film. This increases a bandgap, so that the Schottky barrier height at an interface can be increased.

As the embodiment of the piezoelectric element of the present invention, a crystal structure of the material of the dielectric film on the second electrode side is preferably a perovskite structure, and a total thickness of the piezoelectric film and the dielectric film on the second electrode side preferably falls within a range from 0.1 to 5 $\mu$m. By this means, displacement generation force required for the piezoelectric element can be obtained.

As the embodiment of the piezoelectric element of the present invention, a dielectric film on the first electrode side is preferably provided between the first electrode and the piezoelectric film, and a total thickness of the dielectric film on the second electrode side and the dielectric film on the first electrode side preferably falls within a range from 5 to 15% of a total thickness of the dielectric film on the second electrode side, the dielectric film on the first electrode side and the piezoelectric film. By this means, decrease of an effective piezoelectric constant of the piezoelectric element by insertion of the dielectric body can be kept small, and a Schottky junction can be formed.

As the embodiment of the piezoelectric element of the present invention, the material of the dielectric film on the second electrode side is preferably lead lanthanum titanate. By this means, a leak current can be prevented by forming a Schottky junction.

As the embodiment of the piezoelectric element of the present invention, the Schottky barrier height $\Phi_2$ between the second electrode and the piezoelectric film when a positive electric field of 12.68 V/$\mu$m is applied to the first electrode is preferably equal to or greater than 0.5 eV. This can further reduce a leak current.

A droplet discharge head, a ferroelectric memory, and a piezoelectric actuator of the present invention includes the piezoelectric element of the present invention.

The present invention, components of the present invention, and modes/aspects for implementing the present invention will be described in detail below. Note that in the present application, "-" is used to indicate that numerical values before and after the "-" are included as a lower limit and an upper limit.

<1 Outline of piezoelectric element of the present invention>

The piezoelectric element of the present invention includes a first electrode, a second electrode, and a piezoelectric film located between the first electrode and the second electrode, the first electrode is an electrode to which a relatively positive voltage is applied when the first electrode is driven, the second electrode is an electrode to which a relatively negative voltage is applied when the second electrode is driven, and a coefficient A obtained by the following logarithmic approximation formula in an aging test in which an electric field of 10 V/$\mu$m is applied at an ambient temperature of 80°C is equal to or greater than $-4.200 \times 10^{-2}$.

$$\Phi_2 = A \times \ln(t) + B$$

$\Phi_2$: Schottky barrier height [eV] between the second electrode and the piezoelectric film when a positive electric field 12.68 V/$\mu$m is applied to the first electrode
t: Aging period [h]
A: Coefficient
B: Coefficient

<2 Configuration of piezoelectric element>

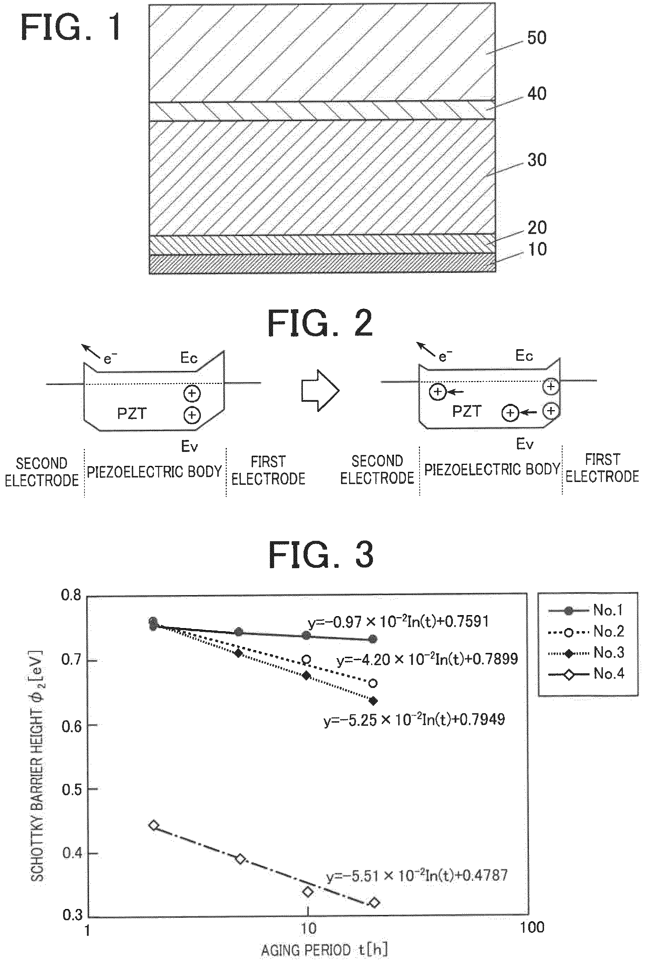

A schematic cross-sectional view of a configuration example of the piezoelectric element of the present invention is illustrated in FIG. 1. The piezoelectric element of the present invention includes a first electrode 10, a second electrode 50, and a piezoelectric film 30 located between the first electrode 10 and the second electrode 50. Further, a dielectric film 40 on the second electrode side is preferably provided between the second electrode 50 and the piezoelectric film 30, and a dielectric film 20 on the first electrode side is further preferably provided between the first electrode 10 and the piezoelectric film 30.

The respective components will be described in detail below.

<2.1 Electrodes>

The first electrode 10 is an electrode to which a relatively positive voltage is applied when the first electrode 10 is driven. A material of the first electrode 10 is not particularly limited, and Cr, Ni, Cu, Pt, Ir, Ti, an Ir-Ti alloy, LaNi03, $SrRuO_3$, or the like, can be used. A thickness of the first electrode 10 preferably falls within a range from 0.1 to 1 $\mu$m.

The second electrode 50 is an electrode to which a relatively negative voltage is applied when the second electrode 50 is driven. A material of the second electrode 50 is not particularly limited, and Cr, Ni, Cu, Pt, Ir, Ti, an Ir-Ti alloy, LaNi03, $SrRuO_3$, or the like, can be used. A thickness of the second electrode 50 preferably falls within a range from 0.5 to 5 $\mu$m.

<2.2 Piezoelectric film>

A "piezoelectric film" is a film formed with a piezoelectric body. A crystal structure of a piezoelectric body that becomes a material of the piezoelectric film 30 according to the present invention is preferably a perovskite structure.

The "perovskite structure" refers to a crystal structure similar to perovskite ($CaTiO_3$). Normally, a composition of the perovskite crystal structure is expressed as $ABX_3$, and in the perovskite crystal structure, A, B and X exist as component ions of A cation, B cation and X anion, respectively. Further, a B cation defect-type perovskite compound, an A cation defect-type perovskite compound, and an X anion defect-type perovskite compound are also defined as compounds having a perovskite crystal structure in the present invention.

Examples of the piezoelectric body having a perovskite structure as a crystal structure can include lead zirconate titanate (PZT: Pb(Zr, Ti)03), lead titanate (PbTi03), lead zirconate ($PbZrO_3$), lead lanthanum titanate (PLT: (Pb, La)$TiO_3$), barium titanate ($BaTiO_3$), and the like. Among these, lead zirconate titanate represented by $Pb_X(Zr_Y, Ti_{1-Y})O_3$ [$0.5 \leq X \leq 1.5$, $0.1 \leq Y \leq 0.9$] is particularly preferable.

Lead zirconate titanate preferably has a nonstoichiometric composition. Specifically, in a case where the composition is represented by $Pb_X(Zr_Y, Ti_{1-Y})O_3$ [$0.5 \leq X \leq 1.5$, $0.1 \leq Y \leq 0.9$], X is preferably $X > 1$.

Further, in a case where the composition is represented by $Pb_X(Zr_Y, Ti_{1-Y})O_3$ [$0.5 \leq X \leq 1.5$, $0.1 \leq Y \leq 0.9$], and, when the piezoelectric film 30 is divided in half in a thickness direction, an atomic composition ratio X of lead on the first electrode side is set as X1 and an atomic composition ratio X of lead on the second electrode side is set as X2, a value of the ratio X1/X2 is preferably equal to or greater than 1.04 and more preferably equal to or greater than 1.11. This can further prevent lowering of the Schottky barrier height in association with use. Further, in terms of prevention of lowering of the Schottky barrier height, X2 is preferably equal to or less than 1.2, and a value of the ratio X1/X2 is preferably equal to or less than 1.14.

The composition of the piezoelectric film 30 can be analyzed by examining the composition in a depth direction of the piezoelectric film by alternately performing ion sputtering using Auger electron spectroscopy.

The atomic composition ratio X of lead can be adjusted by adjusting a partial pressure of oxygen of a sputtering gas when the piezoelectric film 30 is formed. As is known in related art, the atomic composition ratio X of lead can be increased by setting a higher partial pressure of oxygen of the sputtering gas, and the atomic composition ratio X of lead can be reduced by setting a lower partial pressure of oxygen of the sputtering gas. Further, Y is derived from a sputtering target and does not change in the whole piezoelectric film.

In a case where the atomic composition ratio X of lead is changed between the piezoelectric film on the first electrode side and the piezoelectric film on the second electrode side when the piezoelectric film 30 is divided in half in a thickness direction, it is only necessary to change the partial pressure of oxygen of the sputtering gas when half of the film is formed.

Further, in terms of magnitudes of a permittivity and a piezoelectric constant, Y when the composition is represented by $Pb_X(Zr_Y, Ti_{1-Y})O_3$ [$0.5 <\_ X \leq 1.5$, $0.1 \leq Y \leq 0.9$] preferably falls within a range from 0.50 to 0.58 and is more preferably 0.52.

A relationship between a value of the ratio X1/X2 and lowering of the Schottky barrier height in association with use will be described.

In a case where the piezoelectric film is formed using a material including lead like PZT, volatility of lead is high, and thus, the film is formed while lead is excessively added. Excessive lead compared to a stoichiometric composition due to this exists with a positive charge within the film and is called a lead defect. This lead defect has a positive charge, and thus, is encouraged to be diffused to the second electrode side by a positive voltage being applied to the first electrode. The lead defect diffused toward the second electrode side causes lowering of the Schottky barrier height between the second electrode and the piezoelectric film.

Thus, if the composition ratios X1 and X2 of lead are adjusted so that the value of the ratio X1/X2 becomes equal to or greater than 1.04, that is, more lead exists on the first electrode side, when a positive voltage is applied to the first electrode, a period until the lead defect is diffused to an interface of the second electrode becomes long, so that lowering of the Schottky barrier height can be prevented.

FIG. 2 is a schematic view illustrating change of band alignment due to diffusion of a lead defect and charge injection in a case where the piezoelectric body is PZT. The lead defect due to excessive lead and having a positive charge segregated on the first electrode side is diffused to the second electrode side by application of a voltage, reaches an interface of the second electrode and the piezoelectric body and lowers the Schottky barrier height between the second electrode and the piezoelectric film. On the other hand, by injecting charges to an interface of the first electrode and the piezoelectric film, the Schottky barrier height between the first electrode and the piezoelectric film is also lowered.

Further, by a difference in the value of the ratio X1/Y2, a difference also occurs in an aspect of change of a coercive electric field and residual polarization in association with use. If a positive voltage is applied to the first electrode, diffusion of the lead defect to the second electrode side proceeds, which makes an internal bias small. As a result, the coercive electric field is shifted to a positive side, and the residual polarization becomes greater by alleviation of pinning. Thereafter, the coercive electric field reaches an inflection point and is shifted on a negative side, the residual polarization becomes smaller, and pinning proceeds. It can be considered that this is caused by injection of a charge to an interface of the first electrode and the piezoelectric film. As the value of the ratio X1/X2 is greater, that is, as a degree of segregation of the lead defect on the first electrode side is larger, the coercive electric field reaches the inflection point later. It is therefore possible to prevent degradation of the piezoelectric characteristics as the value of the ratio X1/X2 is greater.

A thickness of the piezoelectric film 30 preferably falls within a range from 0.1 to 5 $\mu$m and more preferably falls within a range from 2.0 to 3.5 $\mu$m. By this means, displacement generation force required for the piezoelectric element can be obtained.

<2.3 Dielectric film on second electrode side>

The "dielectric film on the second electrode side" refers to a film formed between the second electrode and the piezoelectric film with a dielectric body. In the present invention, a crystal lattice volume of a material of the dielectric film 40 on the second electrode side is preferably smaller than a crystal lattice volume of the material of the piezoelectric film. This increases a bandgap, and thus, the Schottky barrier height at the interface is increased.

The crystal lattice volume can be measured using an X-ray diffraction (XRD) method. An interval between (001) planes and an interval between (100) planes of the crystal can be respectively obtained as c and a through out-of-plane 2$\theta$-$\omega$ scanning and in-plane 2$\theta$-$\omega$ scanning, and the crystal lattice volume can be calculated by a $\times$ a $\times$ c.

A crystal structure of the dielectric film 40 on the second electrode side is preferably a perovskite structure. Examples of the piezoelectric body having a perovskite crystal structure can include lead titanate (PbTi03), lead lanthanum titanate (PLT: (Pb, La)TiO$_3$), barium titanate (BaTiO$_3$), and the like. Among these, the piezoelectric body containing lead is preferable, and particularly, lead lanthanum titanate is preferable. By this means, a Schottky barrier can be formed at the interface with the PZT by a difference in a crystal lattice volume.

In the piezoelectric element of the present invention, a total thickness of the piezoelectric film 30 and the dielectric film 40 on the second electrode side preferably falls within a range from 0.1 to 5 $\mu$m. By this means, displacement generation force required for the piezoelectric element can be obtained.

<2.4 Dielectric film on first electrode side>

The "dielectric film on the first electrode side" refers to a film formed between the first electrode and the piezoelectric film with a dielectric body. In the present invention, as the dielectric film 20 on the first electrode side, a dielectric film similar to the dielectric film 40 on the second electrode side described above can be used.

A total thickness of the dielectric film on the second electrode side and the dielectric film on the first electrode side preferably falls within a range from 5 to 15% of a total thickness of the dielectric film on the second electrode side, the dielectric film on the first electrode side and the piezoelectric film. By this means, decrease of an effective piezoelectric constant of the piezoelectric element by insertion of the dielectric body can be kept small, and a Schottky junction can be formed.

<3 Coefficient A>

In the piezoelectric element of the present invention, a coefficient A obtained by the following logarithmic approximation formula in an aging test in which an electric field of 10 V/μm is applied at an ambient temperature of 80°C is equal to or greater than -4.200 x $10^{-2}$.

$$\Phi_2 = A \times \ln(t) + B$$

$\Phi_2$: Schottky barrier height [eV] between the second electrode and the piezoelectric film when a positive electric field of 12.68 V/μm is applied to the first electrode
t: Aging period [h]
A: Coefficient
B: Coefficient

The above-described logarithmic approximation formula can be expressed as a graph, for example as indicated in FIG. 3. FIG. 3 is a graph of an example which will be described later. Change in an early stage of aging is important, and thus, the aging period t is set at up to 20 hours.

The coefficient A becomes an index of a degree of prevention of lowering of the Schottky barrier height. The coefficient A is a value equal to or less than 0, and a greater value, that is, a value closer to 0 indicates a smaller degree of lowering of the Schottky barrier height in association with aging.

In the present invention, the coefficient A is equal to or greater than -4.200 x $10^{-2}$. Further, in terms of effects of the present invention, the coefficient A is preferably equal to or greater than -1.000 × $10^{-2}$.

Further, in the piezoelectric element of the present invention, the Schottky barrier height $\Phi_2$ between the second electrode and the piezoelectric film when a positive electric field of 12.68 V/μm is applied to the first electrode before the aging test is preferably equal to or greater than 0.5 eV. This can further reduce a leak current.

<4 Method for measuring Schottky barrier height>

In the present invention, the Schottky barrier height $\Phi_2$ between the second electrode and the piezoelectric film and the Schottky barrier height $\Phi_1$ between the first electrode and the piezoelectric film are collectively referred to as a Schottky barrier height $\Phi_S$.

A method for measuring the Schottky barrier height $\Phi_S$ in the present invention will be described below. Note that the measurement method is similar between in a case where measurement is performed independent of the aging test and in a case where measurement is performed in the aging test.

In the present invention, the Schottky barrier height $\Phi_S$ [eV] is obtained using the following expression from a slope α by creating an Arrhenius plot that indicates ln (1000/T) on a horizontal axis and ln ($J/T^2$) on a vertical axis after measuring leak current density J [A/$cm^2$] at a predetermined temperature T [K] using the following method. Note that at least four kinds of the predetermined temperature T [K] are required to create the Arrhenius plot.

$$\alpha = q\Phi_S/k_B$$

α: Slope of Arrhenius plot
$\Phi_S$: Schottky barrier height [eV]
q: Charge [C]
$k_B$: Boltzmann constant [JIK]

A method for measuring the leak current density J [A/$cm^2$] will be described below.

The piezoelectric element is put into an electric furnace and sealed, and dry air is introduced. It is waited until a dew point becomes equal to or less than -50°C. Then, a temperature of the electric furnace is increased, and an ambient temperature is adjusted at the predetermined temperature T [K]. Here, to avoid influence of fluctuation of the temperature, a fixed period (a period until the temperature becomes stable, for example, approximately 45 minutes) is provided as a waiting period. A temperature measured with a thermocouple thermometer provided near the piezoelectric element is set as the ambient temperature.

An electric field applied between the first electrode and the second electrode is gradually increased from 0 V/μm to 12.86 V/μm in a state where the ambient temperature is adjusted at the predetermined temperature T [K], and current density of the leak current flowing when the electric field is 12.86 V/μm is measured. Here, to obtain a net leak current excluding influence of a polarization inversion current, application is swept in the same direction twice, and current density at the second sweeping is dealt with as the leak current density J [A/$cm^2$].

The electric field is applied so that the first electrode side becomes a positive potential in a case where the

Schottky barrier height $\Phi_1$ between the first electrode and the piezoelectric film is measured while the second electrode is grounded, and is applied so that the first electrode side becomes a negative potential in a case where the Schottky barrier height $\Phi_2$ between the second electrode and the piezoelectric film is measured.

The leak current density is measured using, for example, a semiconductor parameter analyzer (Agilent B1500A).

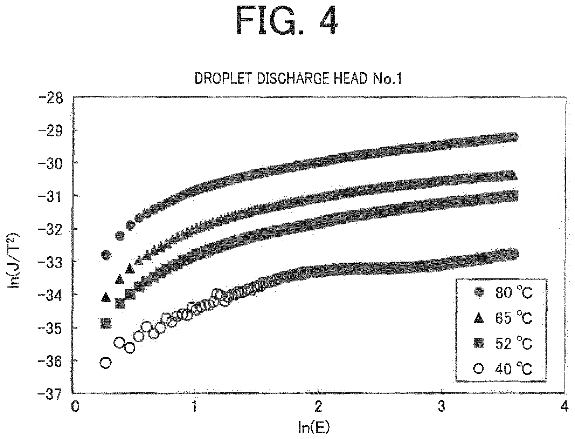

The reason why the leak current density is measured at each temperature when the electric field is 12.86 V/$\mu$m is to perform measurement in an electric field in which a Schottky emission current is dominant. FIG. 4 is a graph in which measurement results using a droplet discharge head No. 1 in the example which will be described later as a sample are plotted in accordance with a theoretical formula (the following formula (1)) of the Schottky emission current, while ln(E) is indicated on the horizontal axis, and ln(J/T$^2$) is indicated on the vertical axis. This graph indicates measurement results at the temperatures of 40°C, 52°C, 65°C and 80°C, and a symbol E represents an electric field [V/$\mu$m]. In the graph in which ln(E) and ln(J/T$^2$) are plotted, an electric field region in which a line connecting the plotted points becomes linear is an electric field region in which it can be regarded that the Schottky emission current dominantly flows. In a case of FIG. 4, the electric field region in which it can be regarded that the Schottky emission current dominantly flows at any temperature is equal to or greater than 7.714 V/$\mu$m. Further, in other samples confirmed in a similar manner, a linear plot can be obtained at an electric field of 12.68 V/$\mu$m, and thus, in the present invention, leak current density at an electric field of 12.68 V/$\mu$m is employed as the leak current density used in evaluation of the Schottky barrier height.

[Expression 1]

$$J = AT^2 \exp\left(-\frac{q\Phi_S - q^3/(4\pi\varepsilon)\sqrt{E}}{k_B T}\right) \quad \cdot \cdot \cdot (1)$$

J: Leak current density [A/cm$^2$]
A: Arbitrary constant
T: Predetermined temperature [K]
q: Charge [C]
$\Phi_S$: Schottky barrier height [eV]
$\varepsilon$: Permittivity [F/m]
E: Electric field [V/$\mu$m]
$k_B$: Boltzmann constant [J/K]

In the present application, the temperature [K] and the temperature [°C] can be converted using the following expression.

$$\text{Temperature [K: kelvin]} = \text{temperature [°C: Celsius]} + 273.15$$

<5 Aging test>

In the present invention, the aging test of the piezoelectric element is performed by continuously applying an electric field of 10 V/$\mu$m for a predetermined period while heating is performed so that the ambient temperature becomes 80°C.

The aging test will be described in detail below.

First, the piezoelectric element is put into an electric furnace and sealed. Dry air is introduced into the electric furnace, and it is waited until a dew point becomes equal to or lower than -50°C. Then, a temperature of the electric furnace is increased, and the ambient temperature is adjusted to 80°C. Here, to avoid influence of fluctuation of the temperature, a fixed period (for example, approximately 45 minutes until the temperature becomes stable) is provided as a waiting period. A temperature measured with a thermocouple thermometer provided near the piezoelectric element is set as the ambient temperature.

If the ambient temperature becomes 80°C, the second electrode is grounded, and application of a positive electric field of 10 V/$\mu$m to the first electrode is started. The electric field is applied using, for example, a DC stabilized power supply (KX-100L). Aging is performed by continuing application of the electric field of 10 V/$\mu$m while keeping the ambient temperature at 80°C.

The aging period t that is an elapsed period since application has been started is set at up to 20 hours. The Schottky barrier height $\Phi_2$ between the second electrode and the piezoelectric film is measured in the middle of the aging several times so that tendency of change in association with aging can be grasped. The measurement is preferably performed at least four times while changing the aging period t. For example, measurement is performed at a time point at which the aging period t is 2, 5, 10 and 20 hours.

<6 Application of piezoelectric element>

The droplet discharge head, the ferroelectric memory, and the piezoelectric actuator of the present invention includes the piezoelectric element of the present invention. Piezoelectric characteristics of the piezoelectric element of the present invention less degrade in association with use, and thus, the droplet discharge head, the ferroelectric memory and the piezoelectric actuator including the piezoelectric element can be stably used for a long period.

If the droplet discharge head, the ferroelectric memory, and the piezoelectric actuator of the present invention include the piezoelectric element of the present invention, other configurations, and the like, are not particularly limited, and they can be constituted using members that are typically used.

The piezoelectric element of the present invention can be used in, for example, a piezoelectric microphone, a vibration sensor, a displacement sensor, a sonar, an oscillation circuit, a resonator, a ceramic filter, a piezoelectric transformer, a piezoelectric buzzer, an ultrasonic motor, and the like, other than the above.

EXAMPLES

The present invention will be specifically described below using examples, but the present invention is not limited to these. Note that while the expressions "part" or "%" are used in the example, the expressions "part" or "%" indicate "parts by mass" or "mass %" unless otherwise specified.

In the examples, droplet discharge heads including the piezoelectric element of the present invention were manufactured, and degradation of the piezoelectric characteristics in association with use was evaluated using the droplet discharge heads.

<Manufacturing of droplet discharge head No. 1>

A first electrode was formed on a Bare-Si wafer of 8 inches using an Ir-Ti alloy target through an RF magnetron sputtering method. A thickness and sputtering conditions are as follows.

Thickness: 0.12 $\mu$m
RF power supply: 0.75 kW
Gas flow rate: Ar : $O_2$ = 38 : 2 sccm
Sputtering pressure: 0.2 Pa
Substrate setting temperature: 350°C

Then, a dielectric film on the first electrode side was formed on the first electrode using a lead lanthanum titanate (PLT: $(Pb_{1.125}, La_{0.1})TiO_3$) ceramic target that is an excessive lead composition including Pb 25% more than a stoichiometric composition that is Pb : La= 0.9 : 0.1 through an RF magnetron sputtering method. A thickness and sputtering conditions are as follows.

Thickness: 0.12 $\mu$m
RF power supply: 2.0 kW
Gas flow rate: Ar : $O_2$ = 39.5 : 0.5 sccm
Sputtering pressure: 0.2 Pa
Substrate setting temperature: 560°C

Further, an interval between planes and a crystal lattice volume of lead lanthanum titanate of the dielectric film on the first electrode side, measured using an X-ray diffraction method are as follows.

Interval between (100) planes a: 3.95 Å
Interval between (001) planes c: 3.94 Å
Crystal lattice volume a $\times$ a $\times$ c: 61.47 Å$^3$

Then, a piezoelectric film was formed on the dielectric film on the first electrode side using a lead zirconate titanate (PZT : $Pb_{1.25}(Zr_{0.52}, Ti_{0.48})O_3$) ceramic target that is an excessive lead composition including Pb 25% more than a stoichiometric composition through an RF magnetron sputtering method. A thickness and sputtering conditions are as follows.

Thickness: 3.26 μm
RF power supply: 3.0 kW
Gas flow rate: AR : $O_2$ = 39.5 : 0.5 sccm
Sputtering pressure: 0.2 Pa
Substrate setting temperature: 550°C

In an initial layer of film formation that becomes the first electrode side, an amount of lead was adjusted by forming a film while increasing a partial pressure of oxygen.

A composition of the piezoelectric film on the first electrode side in a case where the piezoelectric film was divided in half in a thickness direction was $Pb_{X1}(Zr_Y, Ti_{1-Y})O_3$ where X1 was 1.16 and Y was 0.52.

Further, a composition of the piezoelectric film on the second electrode side in a case where the piezoelectric film was divided in half in a thickness direction was $Pb_{X2}(Zr_Y, Ti_{1-Y})O_3$ where X2 was 1.08 and Y was 0.52.

Note that a composition of the piezoelectric film was analyzed by examining a composition in a depth direction of the piezoelectric film by alternately performing ion sputtering using Auger electron spectroscopy.

Further, an interval between planes and a crystal lattice volume of lead zirconate titanate of the piezoelectric film, measured using an X-ray diffraction method are as follows.

Interval between (100) planes a: 4.09 Å
Interval between (001) planes c: 4.08 Å
Crystal lattice volume a × a × c: 68.25 Å$^3$

Then, a dielectric film on the second electrode side was formed on the piezoelectric film using a lead lanthanum titanate (PLT: $(Pb_{1.125}, La_{0.1})TiO_3$) ceramic target that is an excessive lead composition including Pb 25% more than a stoichiometric composition in which Pb : La = 0.9 : 0.1 through an RF magnetron sputtering method. A thickness and sputtering conditions are as follows.

Thickness: 0.12 μm
RF power supply: 2.0 kW
Gas flow rate: Ar : $O_2$ = 39.5 : 0.5 sccm
Sputtering pressure: 0.2 Pa
Substrate setting temperature: 550°C

Further, an interval between planes and a crystal lattice volume of lead lanthanum titanate of the dielectric film on the second electrode side, measured using an X-ray diffraction method are as follows.

Interval between (100) planes a: 3.95 Å
Interval between (001) planes c: 3.94 Å
Crystal lattice volume a × a × c: 61.47 Å$^3$

Then, the second electrode was formed on the dielectric film on the second electrode side using a Cu target through a sputtering method. A thickness and sputtering conditions are as follows. Note that the second electrode also serves as a vibration plate in the piezoelectric actuator.

Thickness: 2.8 μm
DC power supply: 1 kW
Gas flow rate: Ar = 50 sccm
Sputtering pressure: 0.15 Pa
Substrate setting temperature: room temperature

Then, an ink shielding film of 1 μm was formed by applying a photosensitive polyimide resin on the second electrode through a spin coat method and curing the resin by burning at 230°C.

Then, a seed layer of 0.5 μm was formed on the ink shielding film using an Ni target through a sputtering method. Sputtering was performed for 15 minutes at high-frequency power of 500 W and in an argon gas having a gas pressure of 1 Pa upon sputtering.

Then, a pressure chamber with a height of 150 μm was formed by depositing a pressure chamber member made of Ni using an Ni electroforming method after forming two laminated layers of a dry film resist having a thickness of 80 μm of ORDYL MP108 manufactured by Tokyo Ohka Kogyo Co., Ltd. Then, the dry film resist layers were removed, and cleaning and drying were performed.

Then, a support substrate of 8 inches made of glass was pasted on the pressure chamber with a double-sided thermal release sheet manufactured by Nitto Denko Corporation.

Then, the Si substrate was ground until the thickness becomes approximately 50 $\mu$m and completely removed by further performing dry etching using $SF_6$.

Then, a resist mask was formed by applying an OMR resist manufactured by Tokyo Ohka Kogyo Co., Ltd. on the first electrode and transferring a mask pattern and developing the mask pattern through exposure. Then, the first electrode in a region where a resist mask was not formed was removed through dry etching using a mixture gas of argon, oxygen and $CHF_3$. After cleaning, the resist mask was peeled using a stripping solution.

Then, a resist mask was formed by applying an OMR resist manufactured by Tokyo Ohka Kogyo Co., Ltd. and transferring a mask pattern and developing the mask pattern through exposure. Then, the dielectric film and the piezoelectric film in a region where the resist mask was not formed was removed through dry etching using a mixture gas of chlorine and bromine. After cleaning, the resist mask was peeled using a stripping solution.

Then, a protective film of 1 $\mu$m was formed by applying a photosensitive polyimide resin through a spin coat method and further performing patterning. The patterning was performed by transferring a mask pattern and developing the mask pattern through exposure. After patterning, the photosensitive polyimide resin was burned at 210°C and cured.

Then, the support substrate was removed by being heated at a temperature equal to or higher than a temperature at which the thermal release sheet foams, to obtain the piezoelectric actuator No. 1.

Then, an ink channel member and a nozzle plate were bonded to the piezoelectric actuator No. 1 with an adhesive to obtain the droplet discharge head No. 1.

<Manufacturing of droplet discharge head No. 2>

The droplet discharge head No. 2 was manufactured in a similar manner to the droplet discharge head No. 1 except that X1 and X2 of the piezoelectric film were adjusted as indicated in Table 1.

<Manufacturing of droplet discharge head No. 3>

The droplet discharge head No. 3 was manufactured in a similar manner to the droplet discharge head No. 1 except that X1 and X2 of the piezoelectric film were adjusted as indicated in Table 1.

<Manufacturing of droplet discharge head No. 4>

The droplet discharge head No. 4 was manufactured in a similar manner to the droplet discharge head No. 1 except that instead of forming the dielectric film on the second electrode side, the thickness of the piezoelectric film and the dielectric film on the first electrode side was made 3.50 $\mu$m (the piezoelectric film: 3.38 $\mu$m, the dielectric film on the first electrode side: 0.12 $\mu$m) and further, X1 and X2 of the piezoelectric film were adjusted as indicated in Table 1.

<Measurement of Schottky barrier height and coefficient A>

The Schottky barrier heights $\Phi_1$ and $\Phi_2$ before the aging test and during each aging period t of the droplet discharge heads No. 1 to 4 were measured. The measurement results are as indicated in Table 1.

A method of the aging test and a method for measuring the Schottky barrier height are as described above. Note that a distance between electrodes in the droplet discharge heads No. 1 to 4 is 3.50 $\mu$m, and thus, in the aging test, an applied electric field was set at 10.00 V/$\mu$m by setting an absolute value of the applied voltage at 35 V. Further, in measurement of the Schottky barrier height, by setting the absolute value of the applied voltage at 45 V, the applied electric field was set at 12.86 V/$\mu$m.

Four kinds of 2, 5, 10 and 20 hours were set as the aging period t. Further, as the predetermined temperature T in measurement of the Schottky barrier height $\Phi_2$ in each aging period t, a setting temperature of the electric furnace was set at five kinds of 24°C, 40°C, 52°C, 65°C and 80°C, and a temperature acquired with a thermocouple was employed as the ambient temperature and used in evaluation.

A graph in which each aging period t and the Schottky barrier height $\Phi_2$ at that time are plotted is indicated in FIG. 3.

The coefficient A in the droplet discharge heads No. 1 to 4 was derived from the above-described logarithmic approximation formula using the Schottky barrier height $\Phi_2$ in each aging period t. The derived value of the coefficient A is as indicated in Table 1.

<Measurement of decrease rate of injection speed>

Durability of the droplet discharge heads No. 1 to 4 was evaluated with a decrease rate of injection speed obtained using the following method.

The injection speed [m/s] before and after injection for a long period of the droplet discharge heads No. 1 to 4 was measured using a drop watcher, and a decrease rate [%] of the injection speed was obtained using the following expression. The obtained value of the decrease rate [%] of the injection speed is as indicated in Table 1.

$$\text{The decrease rate [\%] of injection speed} = [(S_1 - S_2) / S_1] \times 100$$

$S_1$: Injection speed [m/s] before injection for a long period
$S_2$: Injection speed [m/s] after injection for a long period

A period of injection for a long period was set at 1500 hours. "Under ordinary temperature" in Table I indicates a test in a case where injection was performed for a long period at a room temperature, and "under high temperature" indicates a test in a case where injection was performed for a long period at 50°C. A square wave was employed as an injection waveform, and injection was performed while the second electrode was grounded, and a positive voltage of 30 V was applied to the first electrode.

[Table 1]

TABLE 1

| DROPLET DISCHARGE HEAD No. | CONTENT OF LEAD IN PIEZOELECTRIC FILM | | | SCHOTTKY BARRIER HEIGHT [eV] | | | | | |
|---|---|---|---|---|---|---|---|---|---|
| | | | | $\Phi_1$ | $\Phi_2$ | | | | |
| | X1 | X2 | X1/X2 | BEFORE AGING | BEFORE AGING | t=2h | t=5h | t=10h | t=20h |
| 1 | 1.16 | 1.08 | 1.07 | 0.80 | 0.768 | 0.753 | 0.743 | 0.737 | 0.731 |
| 2 | 1.16 | 1.15 | 1.01 | 0.76 | 0.803 | 0.763 | 0.715 | 0.700 | 0.662 |
| 3 | 1.16 | 1.16 | 1.00 | 0.78 | 0.780 | 0.755 | 0.715 | 0.677 | 0.634 |
| 4 | 1,16 | 1.08 | 1.07 | 0.66 | 0.450 | 0.445 | 0.390 | 0.337 | 0.324 |

TABLE 1 CONTINUED

| DROPLET DISCHARGEHEAD No. | COEFFICIENT A | DECREASE RATE OF INJECTION SPEED [%] | | REMARKS |
|---|---|---|---|---|
| | | UNDER ORDINARY TEMPERATURE | UNDER HIGH TEMPERATURE | |
| 1 | $-0.97 \times 10^{-2}$ | 13 | 21 | PRESENT INVENTION |
| 2 | $-4.20 \times 10^{-2}$ | 26 | 35 | PRESENT INVENTION |
| 3 | $-5,25 \times 10^{-2}$ | MEASUREMENT IMPOSSIBLE | MEASUREMENT IMPOSSIBLE | COMPARATIVE EXAMPLE |
| 4 | $-5.51 \times 10^{-2}$ | 35 | 46 | COMPARATIVE EXAMPLE |

The droplet discharge head No. 3 became unable to perform discharging before 1500 hours had elapsed, and thus, the decrease rate [%] of injection speed could not be measured.

From the evaluation results indicated in Table 1, it can be seen that the droplet discharge head including the piezoelectric element of the present invention has high durability in use for a long period. Further, it can be seen from the results that piezoelectric characteristics of the piezoelectric element of the present invention less degrade in association with use.

<Coercive electric field and residual polarization>

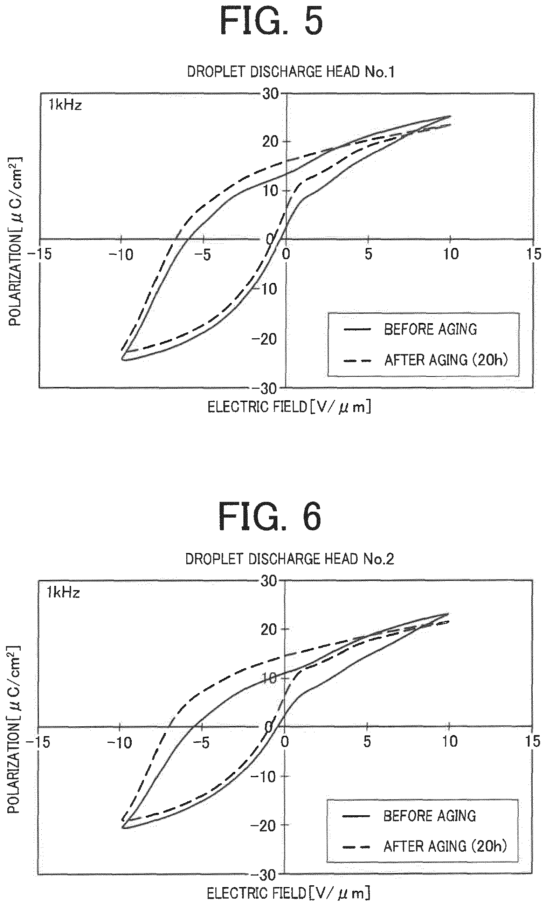

In the droplet discharge heads No. 1 and No. 2 before aging and after 20 hours of aging, P-E characteristics were measured by sweeping the electric field E [V/$\mu$m] at a frequency of 1 kHz and measuring polarization P [$\mu$C/cm$^2$]. P-E characteristics of the droplet discharge head No. 1 are indicated in FIG. 5, and P-E characteristics of the droplet discharge head No. 2 are indicated in FIG. 6. An electric field in a case where a positive voltage is applied to the first electrode side is indicated on a positive side on the horizontal axis, and polarization in a case where positive charges are accumulated in the first electrode is indicated on a positive side on the vertical axis. It can be seen that for both the droplet discharge heads No. 1 and No. 2, P-E loops representing the P-E characteristics are shifted in a negative direction on the horizontal axis due to aging. Further, the P-E loops after aging exhibit favorable rectangularity. Comparing the two droplet discharge heads, a shift amount on the negative side is greater for the droplet discharge head No. 2 than the droplet discharge head No. 1.

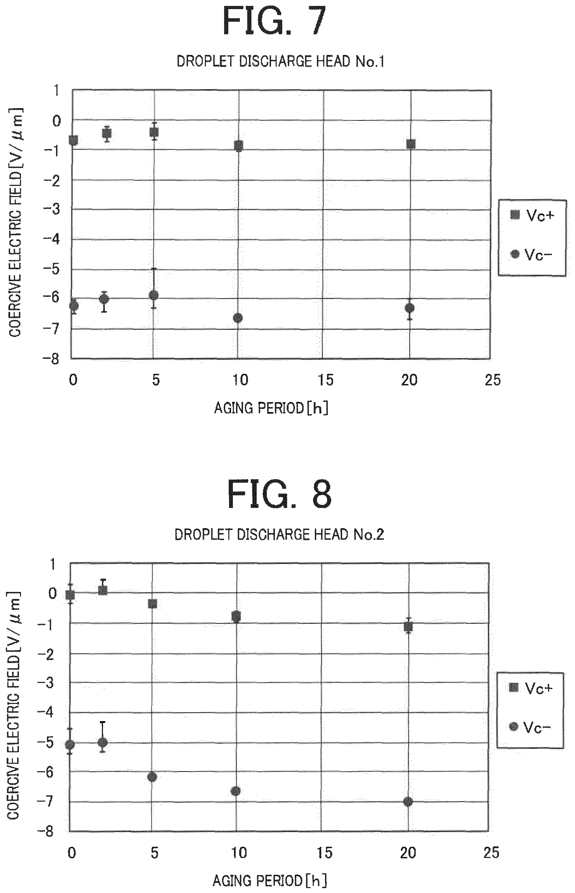

Change of a coercive electric field in association with aging, measured in the droplet discharge head No. 1 is indicated in FIG. 7, and change of a coercive electric field in association with aging, measured in the droplet discharge head No. 2 is indicated in FIG. 8. The coercive electric fields are respectively measured with three different samples, a plot indicates averages, and an error bar indicates a variation range of the value. Between the two coercive electric fields obtained by a difference in an application direction, Vc+ indicates a greater coercive electric field, and Vc- indicates a smaller coercive electric field. For both the droplet discharge head No. 1 and the droplet discharge head No. 2, the coercive electric fields are shifted on the positive side once and then shifted to the negative side. While an inflection point is located near five hours for the droplet discharge head No. 1, an inflection point is located near two hours for the droplet discharge head No. 2.

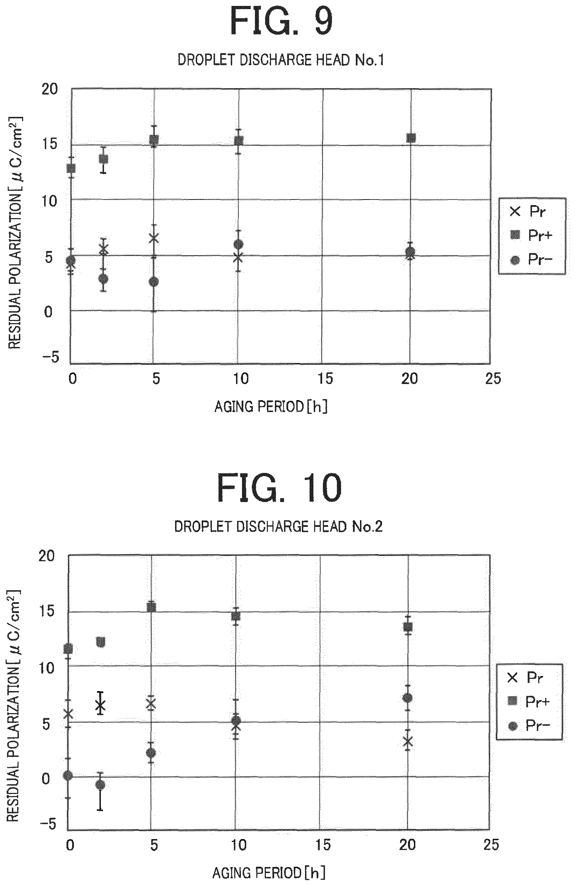

Change of residual polarization in association with aging, measured in the droplet discharge head No. 1 is indicated in FIG. 9, and change of residual polarization in association with aging, measured in the droplet discharge head No. 2 is indicated in FIG. 10. The residual polarization is measured with three different samples, a plot indicates averages, and an error bar indicates a variation range of the value. Between two kinds of residual polarization obtained by a difference in an application direction, Pr+ indicates greater residual polarization, and Pr-indicates smaller residual polarization. Pr is a value obtained by dividing a difference between Pr+ and Pr- by 2, and this value is employed as residual polarization of the sample. Comparing Pr, in a similar manner to the coercive electric field, for both the droplet discharge heads No. 1 and No. 2, Pr increases once in association with aging period and then decreases. The inflection points are respectively located near five hours and two hours for the droplet discharge head No. 1 and the droplet discharge head No. 2 in a similar manner to the coercive electric fields.

Comparing the coercive electric fields before aging, it can be seen that a shift amount to the negative direction is greater for the droplet discharge head No. 1 than the droplet discharge head No. 2. Compared to the droplet discharge head No. 1, the droplet discharge head No. 2 is manufactured to include a more amount of lead as a whole, and thus, a degree of segregation of the lead defect inside is greater for the droplet discharge head No. 1 in a case of relative comparison. Thus, it can be seen from correlation between a degree of segregation of the lead defect and an internal bias that excessive lead has a positive charge and exists within the film.

If aging proceeds, diffusion of the lead defect having a positive charge proceeds by an electric field from the first electrode to the second electrode during aging, which reduces the internal bias. Thus, the coercive electric field is shifted on the positive side, and residual polarization increases by abbreviation of pinning. The inflection point for the droplet discharge head No. 1 comes later than the inflection point for the droplet discharge head No. 2 because a value of the ratio X1/X2 is greater for the droplet discharge head No. 1, that is, a degree of segregation of the lead defect on the first electrode side is greater.

After the coercive electric field reaches the inflection point, the coercive electric field is shifted on the negative side. It can be considered that this is caused by injection of a charge to an interface of the first electrode and the piezoelectric film, the residual polarization also decreases, and pinning proceeds.

INDUSTRIAL APPLICABILITY

The present invention can be utilized in a piezoelectric element with less degradation of piezoelectric characteristics in association with use, a droplet discharge head, a ferroelectric memory, and a piezoelectric actuator including the piezoelectric element.

REFERENCE SIGNS LIST

10    First electrode

20     Dielectric film on first electrode side
30     Piezoelectric film
40     Dielectric film on second electrode side
50     Second electrode

**Claims**

1.  A piezoelectric element comprising a first electrode, a second electrode, and a piezoelectric film located between the first electrode and the second electrode, wherein

    the first electrode is an electrode to which a relatively positive voltage is applied when the first electrode is driven,
    the second electrode is an electrode to which a relatively negative voltage is applied when the second electrode is driven, and
    a coefficient A obtained by the following logarithmic approximation formula in an aging test in which an electric field of 10 V/$\mu$m is applied at an ambient temperature of 80°C is equal to or greater than -4.200 $\times$ 10$^{-2}$.

$$\Phi_2 = A \times \ln(t) + B$$

    $\Phi_2$: Schottky barrier height [eV] between the second electrode and the piezoelectric film when a positive electric field of 12.68 V/$\mu$m is applied to the first electrode
    t: Aging period [h]
    A: Coefficient
    B: Coefficient

2.  The piezoelectric element according to claim 1, wherein the coefficient A is equal to or greater than -1.000 $\times$ 10$^{-2}$.

3.  The piezoelectric element according to claim 1 or 2,

    wherein a crystal structure of a material of the piezoelectric film is a perovskite structure, and
    a thickness of the piezoelectric film falls within a range from 0.1 to 5 $\mu$m.

4.  The piezoelectric element according to any one of claims 1 to 3, wherein a material of the piezoelectric film is lead zirconate titanate.

5.  The piezoelectric element according to any one of claims 1 to 4,

    wherein a material of the piezoelectric film is lead zirconate titanate represented by $Pb_X(Zr_Y, Ti_{1-Y})O_3$ [0.5 $\leq$ X $\leq$ 1.5, 0.1 $\leq$ Y $\leq$ 0.9] in a whole of the piezoelectric film, and
    in a case where when the piezoelectric film is divided in half in a thickness direction, an atomic composition ratio X of lead on the first electrode side is set as X1, and an atomic composition ratio X of lead on the second electrode side is set as X2, a value of a ratio X1/X2 is equal to or greater than 1.04.

6.  The piezoelectric element according to any one of claims 1 to 5, comprising a dielectric film on the second electrode side between the second electrode and the piezoelectric film,
    wherein a crystal lattice volume of a material of the dielectric film on the second electrode side is smaller than a crystal lattice volume of a material of the piezoelectric film.

7.  The piezoelectric element according to claim 6,

    wherein a crystal structure of the material of the dielectric film on the second electrode side is a perovskite structure, and
    a total thickness of the piezoelectric film and the dielectric film on the second electrode side falls within a range from 0.1 to 5 $\mu$m.

8.  The piezoelectric element according to claim 6 or 7, comprising a dielectric film on the first electrode side between the first electrode and the piezoelectric film,

wherein a total thickness of the dielectric film on the second electrode side and the dielectric film on the first electrode side falls within a range from 5 to 15% of a total thickness of the dielectric film on the second electrode side, the dielectric film on the first electrode side and the piezoelectric film.

9.  The piezoelectric element according to any one of claims 6 to 8, wherein the material of the dielectric film on the second electrode side is lead lanthanum titanate.

10. The piezoelectric element according to any one of claims 1 to 9, wherein a Schottky barrier height $\Phi_2$ between the second electrode and the piezoelectric film when a positive electric field of 12.68 V/$\mu$m is applied to the first electrode before an aging test is equal to or greater than 0.5 eV.

11. A droplet discharge head comprising a piezoelectric element,
    the piezoelectric element being a piezoelectric element according to any one of claims 1 to 10.

12. A ferroelectric memory comprising a piezoelectric element,
    the piezoelectric element being a piezoelectric element according to any one of claims 1 to 10.

13. A piezoelectric actuator comprising a piezoelectric element,
    the piezoelectric element being a piezoelectric element according to any one of claims 1 to 10.

# FIG. 1

# FIG. 2

# FIG. 3

# FIG. 4

DROPLET DISCHARGE HEAD No.1

# FIG. 5

DROPLET DISCHARGE HEAD No.1

# FIG. 6

DROPLET DISCHARGE HEAD No.2

# FIG. 7

DROPLET DISCHARGE HEAD No.1

# FIG. 8

DROPLET DISCHARGE HEAD No.2

# FIG. 9

DROPLET DISCHARGE HEAD No.1

# FIG. 10

DROPLET DISCHARGE HEAD No.2

<table>
<tr><th colspan="2">INTERNATIONAL SEARCH REPORT</th><th>International application No.</th></tr>
<tr><td colspan="2"></td><td>**PCT/JP2022/020869**</td></tr>
</table>

**A.    CLASSIFICATION OF SUBJECT MATTER**

*H01L 41/187*(2006.01)i; *B41J 2/14*(2006.01)i; *H01L 27/11507*(2017.01)i; *H01L 41/09*(2006.01)i
FI:    H01L41/187; H01L41/09; H01L27/11507; B41J2/14 301; B41J2/14 607; B41J2/14 613

According to International Patent Classification (IPC) or to both national classification and IPC

**B.    FIELDS SEARCHED**

Minimum documentation searched (classification system followed by classification symbols)

H01L41/187; B41J2/14; H01L27/11507; H01L41/09

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

**C.    DOCUMENTS CONSIDERED TO BE RELEVANT**

| Category* | Citation of document, with indication, where appropriate, of the relevant passages | Relevant to claim No. |
|---|---|---|
| A | JP 2010-201830 A (SEIKO EPSON CORP.) 16 September 2010 (2010-09-16)<br>paragraphs [0019]-[0034], fig. 1-12 | 1-13 |
| A | JP 2019-47114 A (ROHM CO., LTD.) 22 March 2019 (2019-03-22)<br>paragraphs [0014]-[0019], fig. 1-11 | 1-13 |
| A | JP 2012-9661 A (KONICA MINOLTA HOLDINGS, INC.) 12 January 2012 (2012-01-12)<br>paragraphs [0023]-[0047], fig. 1-3 | 1-13 |
| A | JP 2008-294345 A (SEIKO EPSON CORP.) 04 December 2008 (2008-12-04)<br>paragraphs [0018]-[0024], fig. 1-3 | 1-13 |

☐ Further documents are listed in the continuation of Box C.        ☑ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **01 August 2022** | **09 August 2022** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

**INTERNATIONAL SEARCH REPORT**
Information on patent family members

International application No.

**PCT/JP2022/020869**

| Patent document cited in search report | | | Publication date (day/month/year) | Patent family member(s) | Publication date (day/month/year) |
|---|---|---|---|---|---|
| JP | 2010-201830 | A | 16 September 2010 | US 2010/0225711 A1 paragraphs [0034]-[0049], fig. 1-12 | |
| JP | 2019-47114 | A | 22 March 2019 | US 2019/0081230 A1 paragraphs [0032]-[0040], fig. 1-11 | |
| JP | 2012-9661 | A | 12 January 2012 | (Family: none) | |
| JP | 2008-294345 | A | 04 December 2008 | (Family: none) | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2010070394 A